(19) Europäisches Patentamt
European Patent Office
Office européen des brevets

(11) **EP 1 677 350 B1**

(12) **EUROPEAN PATENT SPECIFICATION**

(45) Date of publication and mention
of the grant of the patent:
**02.02.2011 Bulletin 2011/05**

(51) Int Cl.:
*H01L 27/092* (2006.01)  *H01L 21/8238* (2006.01)
*H01L 27/12* (2006.01)  *H01L 21/84* (2006.01)
*H01L 29/786* (2006.01)

(21) Application number: **05028620.2**

(22) Date of filing: **29.12.2005**

(54) **Semiconductor device having surface regions with different crystal orientation and manufacturing method**

Halbleiter-Bauelement mit Oberflächengebieten unterschiedlicher Kristallausrichtungen und Herstellungsverfahren

Dispositif semi-conducteur ayant des zones de surface à orientations cristallines différentes et procédé de fabrication

(84) Designated Contracting States:
**DE FR GB**

(30) Priority: **04.01.2005 KR 2005000584**
**18.11.2005 US 281599**

(43) Date of publication of application:
**05.07.2006 Bulletin 2006/27**

(73) Proprietor: **Samsung Electronics Co., Ltd.**
**Suwon-si, Gyeonggi-do (KR)**

(72) Inventors:
• **Shin, Dong-Suk**
**Yongin-si**
**Gyeonggi-do (KR)**
• **Rhee, Hwa-Sung**
**Bundang-gu**
**Sungnam-si**
**Gyeonggi-do (KR)**
• **Ueno, Tetsuji**
**Yeongtong-gu**
**Suwon-si**
**Gyeonggi-do (KR)**
• **Lee, Ho**
**Chonan-si**
**Chungnam (KR)**
• **Lee, Seung-Hwan**
**Yeongtong-gu**
**Suwon-si**
**Gyeonggi-do (KR)**

(74) Representative: **Weller, Erich W.**
**Patentanwälte Ruff, Wilhelm,**
**Beier, Dauster & Partner**
**Kronenstrasse 30**
**70174 Stuttgart (DE)**

(56) References cited:
**EP-A- 1 555 688** **WO-A-97/16854**
**WO-A-03/003470** **US-A1- 2003 190 791**
**US-A1- 2003 227 036** **US-B1- 6 645 797**

• **XIANG Q ET AL: "Sidewall faceting and inter-facet mass transport in selectively grown epitaxial layers on SiO2-masked Si(1 1 0) substrates" JOURNAL OF CRYSTAL GROWTH, ELSEVIER, AMSTERDAM, NL, vol. 175-176, no. 3001, May 1997 (1997-05), pages 469-472, XP004091338 ISSN: 0022-0248**
• **CHANG L ET AL: "CMOS CIRCUIT PERFORMANCE ENHANCEMENT BY SURFACE ORIENTATION OPTIMIZATION" IEEE TRANSACTIONS ON ELECTRON DEVICES, IEEE SERVICE CENTER, PISACATAWAY, NJ, US, vol. 51, no. 10, October 2004 (2004-10), pages 1621-1627, XP001211140 ISSN: 0018-9383**
• **XUSHENG WU ET AL: "Impact of non-vertical sidewall on sub-50nm FinFET" 2003 IEEE INTERNATIONAL SOI CONFERENCE PROCEEDINGS. NEWPORT BEACH, CA, SEPT. 29 - OCT. 2, 2003, IEEE INTERNATIONAL SOI CONFERENCE, NEW YORK, NY : IEEE, US, 29 September 2003 (2003-09-29), pages 151-152, XP010666061 ISBN: 0-7803-7815-6**

**Description**

The invention relates to a semiconductor device, in particular a semiconductor device having a complementary metal-oxide-silicon (CMOS) construction, and to a method of manufacturing the same.

Semiconductor devices are fabricated from multiple layers of conducting, insulating, and semiconducting material layers and patterns. With respect to single crystal semiconductor materials in particular, the properties of such layers depend in part on the crystal orientation of the exposed surfaces into which dopants are implanted and/or additional patterns are formed.

In general, the most commonly utilized crystal orientation for silicon wafers used in VLSI (Very Large Scale Integration) device fabrication processes is the (100) crystal orientation. The semiconductor manufacturing industry has tended to adopt the (100) surface orientation over the (111) crystal orientation in part to take advantage of the lower surface state density on thermally oxidized surfaces associated with the (100) surface. For example, a surface having a (111) crystal orientation may exhibit a surface state charge density of approximately $5 \times 10^{11}$ e/cm$^2$, while a corresponding surface having a (100) crystal orientation may exhibit a surface state charge density of approximately $9 \times 10^{10}$ e/cm$^2$, a reduction of about 80%. Similarly, surfaces having a (110) crystal orientation can exhibit a surface state charge density of approximately $2 \times 10^{11}$ e/cm$^2$, still approximately twice the surface charge density of corresponding (100) surfaces.

As will be appreciated by those skilled in the art, the lattice planes and directions relation to a particular crystalline structure are commonly expressed using Miller indices, i.e., a grouping of three numbers h, k and 1 that are set off by additional surrounding characters for indicating a specific direction, i.e., [1,-1,0], a family of equivalent directions, i.e., <110>, a specific plane, *i.e.*, (110), or a family of equivalent planes, *i.e.*, {110}. This notation may be utilized with various crystal unit cells including simple cubic (SC), body-centered cubic (BCC), face-centered cubic (FCC) and diamond (DIA or C) which may be considered a modified FCC. Silicon and germanium, for example, are typically considered to have a diamond crystalline structure.

Surface state density can be a particularly important consideration for NMOS technologies as a result of the difficulties associated with higher surface state density levels for accurately controlling the active and parasitic device threshold voltages for devices fabricated on such surfaces. As semiconductor device fabrication methods and device design have improved, the differences in surface state densities have become somewhat less problematic. For example, the difference in surface state density levels between surfaces having (100) and (110) crystal orientations may translate a voltage offset of about 0.1 volts in the active device threshold voltage. Offsets of this magnitude may be and are routinely compensated through the use of a surface threshold voltage ion implant. Another benefit for NMOS devices formed on surfaces having lower surface state charge densities flows from improved electron mobility in inversion layers formed on surfaces having a (100) crystal orientation when compared with surfaces.

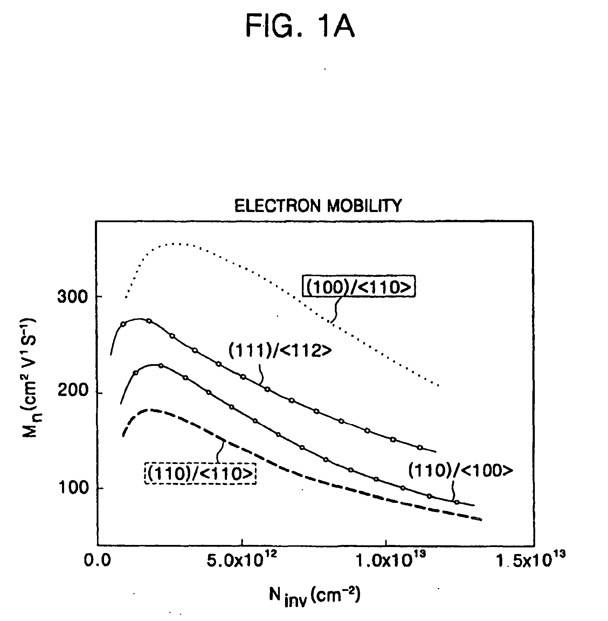

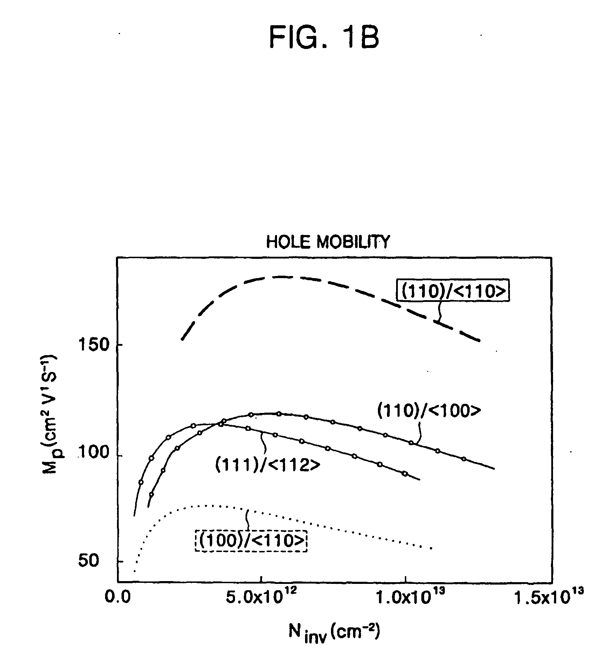

As illustrated in FIGS. 1A and 1B, electron and hole mobility can vary widely with the orientation of the channel region surface and the direction of the carrier flow within that channel region. As reflected in the relative mobility values illustrated in FIGS. 1A and 1B, a particular combination of crystal orientation and carrier direction that improves hole mobility tends to suppress electron mobility simultaneously. As a result, while electron mobility is higher on (100) substrates, particularly with current flow in the <110> direction, hole mobility is highest on (110) substrates with current flow in the <110> direction. The relative mobility of the corresponding carriers, in turn, affects the sizing and/or performance of the resulting semiconductor devices and tends compromise the performance of either the NMOS or the PMOS devices when the devices are formed in semiconductor regions having the same crystal orientation.

Semiconductor surfaces having a (110) crystal plane orientation have been investigated, particularly in the context of Silicon On Insulator (SOI) technologies, by using (110) substrate wafers and/or by inducing recrystallization of the surface of a substrate wafer to produce regions having a (110) crystal orientation. These efforts, however, have required adaptation of the structures and processes that have been developed for the more standard (100) crystalline plane orientation and/or require difficult and/or costly additional processing steps and procedures.

US 2003/0190791 A1 and WO 97/16854 A1 discloses semiconductor devices having slanted, faceted semiconductor surface structures of triangular shape which are formed by a subtractive etching technique. In US 2003/0190791 A1 the structure is used for a n-channel field effect transistor (FET), and laterally spaced therefrom a planar p-channel FET of usual rectangular shape of the gate structure can be provided. The triangular surface structure of the n-channel FET extends from an underlying layer of a substrate, and a channel region for the p-channel FET is provided by a rectangular semiconductor layer structure from the same layer. This layer is blanket deposited and then etched to form the triangular structure. WO 97/16854 A1 indicates that a sharp edge of the triangular structure has an advantageous effect and that this effect may also be achieved by using channel regions of prism-like shape having a polygonal section with arbitrary number of corners.

US 2003/0227036 A1 discloses to arrange an n-channel metal/insulator/semiconductor field effect transistor (MISFET) of planar, rectangular shape and a p-channel MISFET of board or fin shape laterally spaced apart from one another on a common insulating layer. In this structure the channel region of the p-channel MISFET extends from the insulating layer to a larger height than the channel region of the n-channel MISFET.

WO 03/003470 A2 discloses a field effect transistor structure in which edges of a silicon oxide trench isolation are rounded in a groove-like shape through an oxide etching process.

Faceted epitaxially grown silicon structures and their effect on inter-facet mass transport are disclosed in Q. Xiang et al., Sidewall faceting and inter-facet mass transport in selectively grown epitaxial layers on SiO2-masked Si (110) substrates, Journal of Crystal Growth 175/176 (1997), page 469.

Accordingly, it is the technical problem underlying the invention to provide a semiconductor device and a corresponding manufacturing method which are capable to reduce or avoid the above mentioned inconveniences of the prior art and in particular allow favourable carrier mobility and to use processes that are generally compatible with conventional processing materials and techniques without necessitating unduly complex or costly additional processing steps.

The invention solves this problem by providing a semiconductor device having the features of claim 1 and a manufacturing method having the features of claim 9. Advantageous embodiments of the invention are mentioned in the dependent claims, the wording of which is herewith incorporated into the description by reference to avoid unnecessary text repetition.

Processes and techniques according to embodiments of the invention provide semiconductor substrates for fabrication of semiconductor devices, particularly CMOS devices, that include selectively formed, high quality monocrystalline surface regions exhibiting different crystalline orientations. The n-channel metal-oxide-silicon (NMOS) and p-channel metal-oxide-silicon (PMOS) devices of the invention can be provided with channel regions having different crystal plane orientations for enhancing the relative performance of the NMOS and/or the PMOS devices and the invention provides methods for fabricating such channel regions on a single semiconductor substrate. This application claims benefit of priority from Korean Patent Application No. 2005-0000584, which was filed on January 4, 2005, the entire contents of which are incorporated herein by reference.

Processes and techniques according to embodiments of the invention provide semiconductor devices in which the NMOS devices are fabricated in a first semiconductor region configured for improving the performance of a corresponding NMOS device fabricated in a second semiconductor region.

Processes and techniques according to embodiments of the invention provide semiconductor devices in which the PMOS devices are fabricated in the second semiconductor region configured for improving the performance of a corresponding PMOS device fabricated in the first semiconductor region

Processes and techniques according to embodiments of the invention provide semiconductor substrates on which the first or second semiconductor regions incorporate a projecting single crystal structure having facets having surfaces exhibiting at least one crystal orientation not expressed or exposed in the other semiconductor region.

Processes and techniques according to embodiments of the invention provide semiconductor substrates on which the first or second semiconductor regions incorporate a plurality of projecting single crystal structures having facets having surfaces exhibiting at least one crystal orientation not expressed or exposed in the other semiconductor region.

Processes and techniques according to embodiments of the invention may be used to fabricate a semiconductor device having a semiconductor substrate having a first active area and a second active area. The first active area includes a first primary semiconductor surface having a first crystal orientation, a gate dielectric layer formed on the first primary surface, and a gate electrode formed on the gate dielectric layer. Similarly, the second active area includes a second primary semiconductor surface having the first crystal orientation, a faceted epitaxial semiconductor structure grown from the second primary semiconductor surface having at least one facet surface that has a second crystal orientation, a gate dielectric formed on the facet surfaces, and a gate electrode formed on the gate dielectric.

Semiconductor devices as described above may be configured whereby the faceted epitaxial semiconductor structure has a first pair of facet surfaces that have the second crystal orientation and a second pair of facet surfaces that have a third crystal orientation. The faceted epitaxial semiconductor structure may also include a top surface having the first crystal orientation arranged between a pair of facet surfaces that form obtuse angles with the top surface and exhibit a second crystal orientation.

The faceted epitaxial semiconductor structure may be fabricated to include a core material and a surface layer in which the core material exhibits a first lattice constant $L_c$ and the surface layer exhibits a second lattice constant $L_s$. In some embodiments, these first and second lattice constants may satisfy the expression $L_c > L_s$. Furthermore, the core material and surface layer may be selected from a group consisting of Si, SiC, SiGe and Ge and configured so that the first and second lattice constants satisfy the expression $L_c < L_s$.

The substrate on which the semiconductor device is formed may be configured whereby the first crystal orientation is (110), a PMOS device is formed on the first active area and a NMOS device is formed on the second active area. The faceted epitaxial semiconductor structure provided on such a substrate may include a first pair of facet surfaces that have a crystal orientation of (100).

Alternatively, in an example not forming part of the invention, the substrate on which the semiconductor device is formed may be configured whereby the first crystal orientation is (100), a NMOS device is formed on the first active area and a PMOS device is formed on the second active area. The faceted epitaxial semiconductor structure provided on such as substrate may include a first pair of facet surfaces have a crystal orientation of (110).

Further still, the substrate on which the semiconductor device is formed may be configured whereby two faceted epitaxial semiconductor structures are formed on the second primary semiconductor surface, each of the faceted epitaxial semiconductor structures including at least two facet surfaces that have a second crystal orientation. This pair of faceted epitaxial semiconductor structures may be separated and arranged in a parallel orientation or may be arranged to provide some rotational offset between the longitudinal axes of the faceted epitaxial semiconductor structures.

Whether the semiconductor device includes one or more faceted epitaxial semiconductor structures are formed in a single active region, the subsequent processing may be similar whereby gate dielectric layers may be formed on the facet surfaces of the faceted epitaxial semiconductor structures after which a gate electrode may be formed on the gate dielectric layers.

Another method for forming a semiconductor device in accord with an embodiment of the invention will include forming a first active area having a first primary semiconductor surface and a second active area having a second primary semiconductor surface wherein both the first and second primary semiconductor surfaces having a first crystal orientation. A faceted epitaxial semiconductor structure having a least two facet surfaces exhibiting a second crystal orientation may then be formed on one of the primary semiconductor surfaces. Gate dielectric layers may then be formed on the first primary semiconductor surface and the facet surfaces, and gate electrodes formed on the gate dielectric layers.

The faceted epitaxial semiconductor structures fabricated in accord with the invention may be of varying complexity, including embodiments in which the faceted epitaxial semiconductor structures are formed with a first pair of facet surfaces exhibiting the second crystal orientation and a second pair of facet surfaces exhibiting a third crystal orientation. Similarly, the faceted epitaxial semiconductor structure may be formed with a first pair of facet surfaces exhibiting the second crystal orientation and a top surface having the first crystal orientation arranged or extending between a pair of facet surfaces that form obtuse angles with the top surface.

As suggested above, the faceted epitaxial semiconductor structures may be fabricated by forming a core material and forming a surface layer on the core material. The core material may be selected or fabricated to exhibit a first lattice constant $L_C$, while the surface layer may be selected or fabricated to exhibit a second lattice constant $L_S$, whereby the first and second lattice constants will satisfy the expression $L_c > L_S$. Alternatively, the materials may be selected or fabricated whereby the first and second lattice constants will satisfy the expression $L_C < L_S$. Both the core and surface layer materials may be selected from a group of semiconducting materials consisting of Si, SiC, SiGe and Ge.

Other suitable semiconducting materials, including binary, tertiary and even quaternary materials representing combinations of elements selected from one or more of the II, III, IV, V and VI columns of the periodic table may be suitable for some applications and the particular combination of elements and/or the relative stoichiometric ratios of the same basic combination of elements may vary between the core material and the surface layer material. As will be appreciated by those skilled in the art, the use of heterogeneous semiconducting materials fabricated from atoms having different atomic radii can also be used to form "strained" layers resulting from a crystal lattice mismatch between successive material layers in which the upper layer is in tension or compression. Incorporating one or more strained layers into the basic semiconductor structures utilized in practicing various embodiments of the invention may provide an additional technique for adjusting the relative performance of the NMOS and PMOS transistors.

As will be appreciated by those skilled in the art, the semiconductor device according to the invention may incorporate a region having a first crystal orientation of (110) with the PMOS devices formed on the first active area and the NMOS devices formed on the second active area. The faceted epitaxial semiconductor structures may be fabricated to exhibit a first pair of facet surfaces having a crystal orientation of (100).

Conversely, the semiconductor device according to the invention may incorporate a region having a first crystal orientation of (100) with the NMOS devices formed on the first active area and the PMOS devices formed on the second active area and faceted epitaxial semiconductor structures fabricated to exhibit a first pair of facet surfaces having a crystal orientation of (110).

As will be appreciated by those skilled in the art, the semiconductor device according to the invention may incorporate a region having first and second faceted epitaxial semiconductor structures arranged in a parallel orientation on the second primary semiconductor surface, each of the first and second faceted epitaxial semiconductor structures includes least two facet surfaces. Gate dielectric layers may then be formed on the facet surfaces of the first and second faceted epitaxial semiconductor structures one or more gate electrodes may be formed on the gate dielectric layers.

The invention will become more apparent by describing in detail exemplary embodiments thereof with reference to the attached drawings in which:

FIGS. 1A and 1B illustrate the mobility of electrons and holes through substrates having different crystal orientations and/or different current directions;

FIG. 2A illustrates a conventional SOI process incorporating a selective epitaxial growth (SEG) process that can be used to fabricate the part of semiconductor device illustrated in FIG. 2B;

FIGS. 3A and 3B illustrate a NMOS transistor and a PMOS transistor, respectively, fabricated in accord with an embodiment of the invention;

FIG. 4 illustrates both a first transistor and a second transistor, respectively, fabricated on semiconductor regions having different crystal orientations in accord with an embodiment of the invention;

FIGS. 5A and 5B illustrate two alternative constructions for the faceted semiconductor regions and the corresponding crystalline orientation information that can be fabricated and utilized according to an embodiment of the invention;

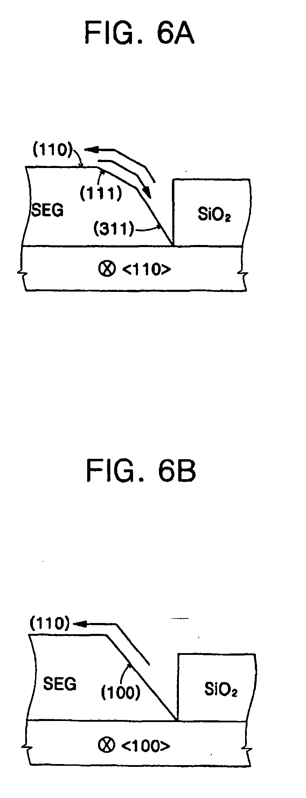

FIGS. 6A and 6B illustrate two alternative constructions for the faceted semiconductor regions that can be fabricated and utilized according to an embodiment of the invention;

FIGS. 7A-7E illustrate cross-sections corresponding to certain process steps in the fabrication of semiconductor devices according to an embodiment of the invention;

FIG. 8 illustrates an embodiment according to the invention in which a plurality of faceted structures are incorporated in a single active region; and

FIGS. 9A-9C illustrate cross-sections corresponding to certain process steps in the fabrication of semiconductor devices according to an embodiment of the invention including a plurality of faceted structures in a single active region.

These drawings have been provided to assist in the understanding of the exemplary embodiments of the invention as described in more detail below and should not be construed as unduly limiting the invention. In particular, the relative spacing, positioning, sizing and dimensions of the various elements illustrated in the drawings are not drawn to scale and may have been exaggerated, reduced or otherwise modified for the purpose of improved clarity.

Those of ordinary skill in the art will also appreciate that a range of alternative configurations have been omitted simply to improve the clarity and reduce the number of drawings. Those of ordinary skill will appreciate that certain of the various process steps illustrated or described with respect to the exemplary embodiments may be selectively and independently combined to create other methods useful for manufacturing semiconductor devices without departing from the scope of this disclosure.

As illustrated in FIGS. 1A and 1B, the mobility of electrons and holes, *i.e.,* the carriers for the respective NMOS and PMOS devices used to construct semiconductor devices, particularly CMOS devices, depends on the crystal orientation, the current flow direction and the carrier concentration. As also illustrated in FIGS. 1A and 1B, the combinations of crystal orientation and current flow direction that tend to enhance the mobility of one type of carrier tends to suppress or degrade the mobility of the other type of carrier. For example, while electron mobility is highest on a substrate exhibiting a (100) crystal orientation, hole mobility is highest on a substrate exhibiting a (110) crystal orientation. Similarly, even within a single crystal orientation the actual direction of current flow will affect the carrier mobility. For example, hole mobility in a substrate exhibiting a (110) crystal orientation will be higher in the <110> direction than in the <100> direction.

Because the carrier mobility in the inversion layers of the respective NMOS and PMOS devices will directly affect the performance of the final semiconductor device, fabricating semiconductor devices using only a single crystal orientation necessarily degrades or compromises the overall performance of the device. These degrading effects can be mitigated to some degree by adjusting the structure of the affected devices by, for example, increasing the relative channel width to provide increased current flow. However, the need for an asymmetrical design for the NMOS and PMOS devices fabricated on a single substrate complicates device design and decreases the degree of integration that can be achieved.

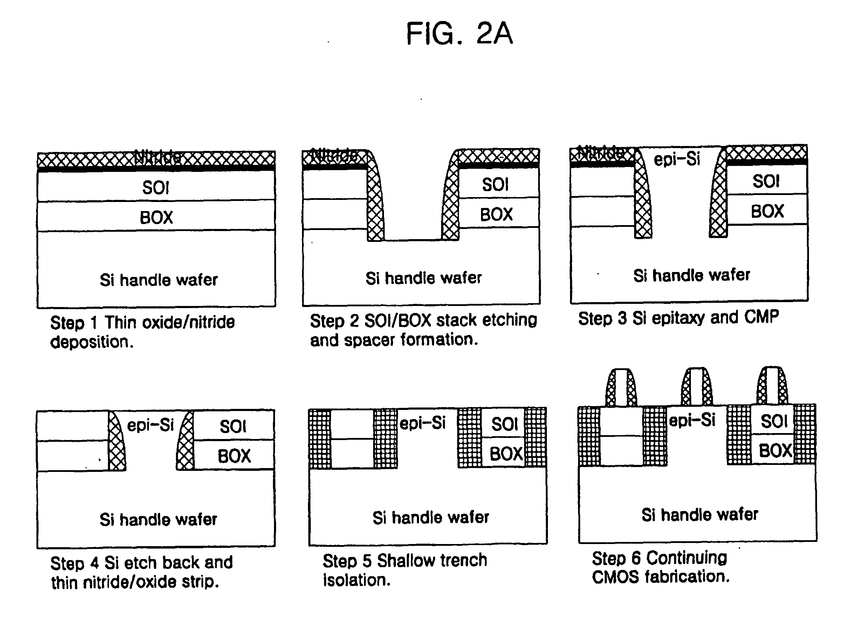

As noted above, efforts have been made to prepare hybrid semiconductor substrates having regions exhibiting different crystal orientations. Certain of the processing steps for preparing such substrates are illustrated in FIG. 2A. As reflected in FIG. 2A, the fabrication begins with a silicon handle wafer having a first crystal orientation on which is formed a buried oxide layer (BOX). A silicon on insulator (SOI) layer is then formed on the BOX layer with the SOI layer having a crystal orientation different from that of the handle wafer.

A masking pattern of another material, for example silicon nitride, may then be formed on the SOI layer and, along with the SOI layer and the BOX layer, etched to expose surface regions of the handle wafer. An epitaxial process may then be used to fill the opening created with single crystal semiconductor material and produce a substrate having a substantially planar surface exhibiting regions having different crystal orientations separated by shallow trench isolation (STI) dielectric regions.

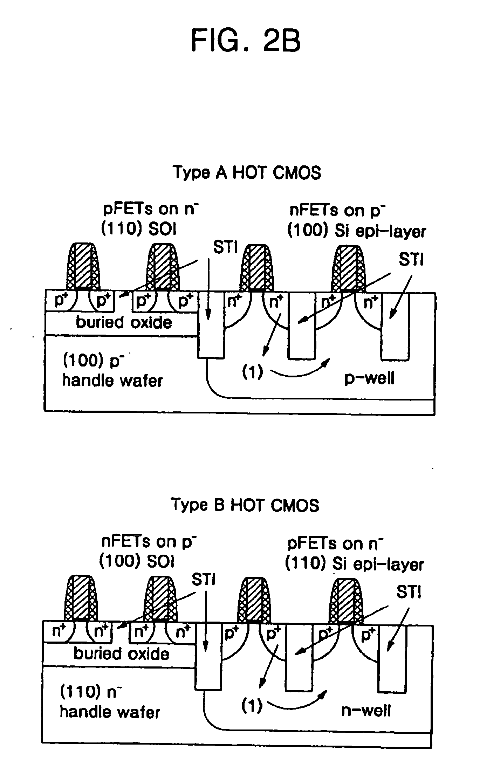

As will be appreciated by those skilled in the art, the relative crystal orientations and doping levels in the exposed SOI and bulk surfaces will determine their relative suitability for the fabrication of NMOS and PMOS transistors as reflected in FIG. 2B. For example, when the handle or bulk wafer has a (100) crystal orientation and a p- doping level, the NMOS devices will be formed in the epitaxial material grown from the exposed surfaces of the bulk or handle wafer and the PMOS devices will be formed in the SOI regions that have a (110) crystal orientation and an n- doping level.

In accord with an embodiment of the invention, NMOS devices may be formed on a surface or active region exhibiting a surface having a (100) crystal orientation and PMOS devices may be formed on a surface of active region exhibiting a surface having a (110) crystal orientation formed through a combination of wafer bonding (SOI) and selective epitaxial growth (SEG) techniques. Once the differently oriented active regions are defined, the NMOS and PMOS devices that will, in combination, comprise the semiconductor device, may be formed on the appropriately configured substrate regions, thereby better matching the carriers with beneficially and differently oriented crystal surfaces.

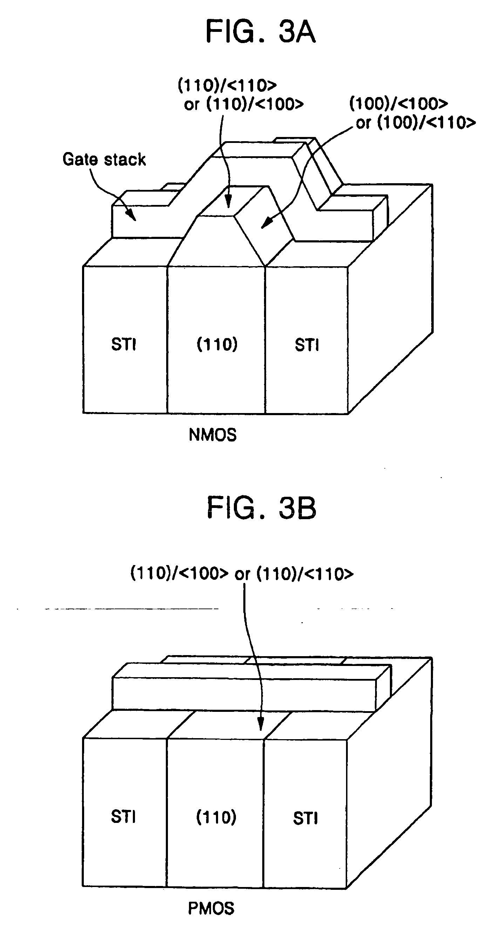

As illustrated in FIGS. 3A and 3B, a semiconductor device fabricated in accord with this invention will include both NMOS and PMOS devices fabricated on single crystal semiconductor materials exhibiting dissimilar crystal orientations. As reflected in FIG. 3A, the NMOS device may be formed on a region of a bulk wafer having a (110) crystal orientation on which is formed a faceted epitaxial semiconductor structure that includes facet surfaces exhibiting a more preferred crystal orientation, for example (100). Depending on the relative configuration of the transistor, the current flow through the NMOS device may be directed in more than one direction, for example a <100> direction or a <110> direction, thereby providing another level of control for the carrier mobility in semiconductor devices fabricated according to an embodiment of the invention.

Conversely, as reflected in FIG. 3B, the corresponding PMOS device may be formed on a region of a bulk wafer having a (110) crystal orientation and on which no faceted epitaxial semiconductor structure have been formed. Again depending on the relative configuration of the transistor, the current flow through the PMOS device may be directed in more than one direction, for example a <100> direction or a <110> direction, thereby providing another level of control for the relative carrier mobility of electrons and holes in semiconductor devices fabricated according to an embodiment of the invention.

For the semiconductor device configuration illustrated in FIGS. 3A and 3B, a major portion of the NMOS channel length is formed on a (100) facet of epitaxial layer, thereby increasing the electron mobility above that which could be achieved in the bulk or handle wafer material. With respect to the corresponding PMOS device, by forming the transistor on (110) bulk substrate surface, a higher hole mobility is maintained as opposed to that which could be achieved on the (100) material exhibited on the facets. As a result, the overall performance of the resulting device may be improved and/or the integration density may be increased without sacrificing performance.

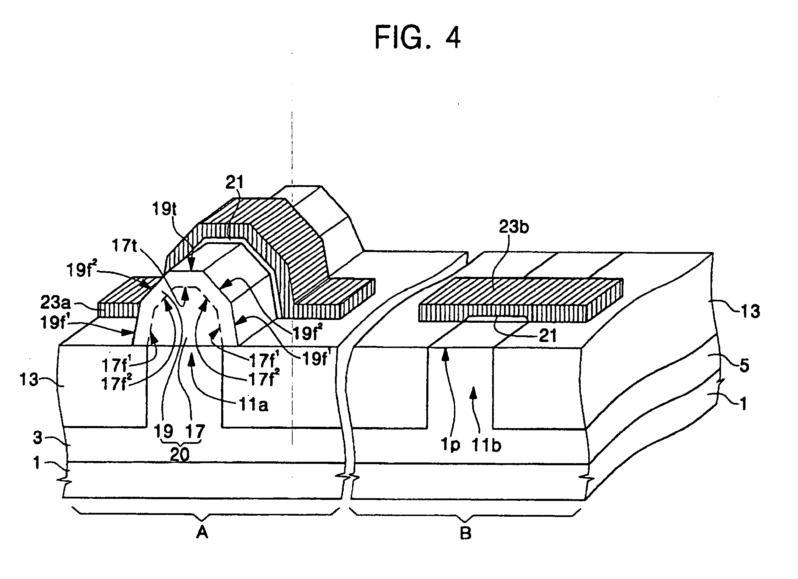

Turning to an embodiment of the invention as illustrated in FIG. 4, the illustrated semiconductor device is formed on a semiconductor substrate 1 that is separated into a first transistor area A and a second transistor area B with insulating material 13, for example a STI layer, arranged between the corresponding transistor areas. The first and second transistor areas A, B also include a first conductivity type well 3 and a second conductivity type well 5. The surface of the substrate 1 exhibits a first crystal orientation 1p and will typically be formed from Si, SiGe, SiC and combinations thereof or other semiconductor materials having sufficiently similar crystal structures although, as indicated above, certain other semiconductor materials may be suitable for some applications. The first transistor area A includes a first active region 11a with the second transistor area B that includes a second active region 11b.

As illustrated in FIG. 4, an epitaxial pattern 20 may be formed on the first active region 11a and may include both a core or first epitaxial layer or pattern 17 that is, in turn, covered with a surface layer or shell epitaxial layer 19. Both of the core and surface layers (or epitaxial patterns) 17, 19, may be fabricated using a selective epitaxial growth (SEG) process while largely limiting its effects to the portion of the substrate exposed in the first transistor area A. As shown in FIG. 4, the epitaxial pattern 20 may include a surface layer 19, a top facet 19t, e.g., a facet that substantially parallels the surface of the base substrate, a first pair of facets $19f^1$ and a second pair of facets $19f^2$ that exhibit crystal orientations different than the crystal orientation of the semiconductor substrate 1p. If present, the surface layer 19 will typically exhibit the same facet surface orientations as the core material 17, but may have a different lattice constant.

The epitaxial pattern 20 includes a faceted core material 17, with or without the optional surface layer 19, which includes a corresponding series of facets having a top surface 17t, a pair of first facets $17f^1$ and a pair of second facets $17f^2$. A gate dielectric 21, for example, an oxide and/or another insulating material suitable for the subsequent fabrication steps and/or methods, is then formed over the channel structures. First and second gate electrodes 23a, 23b, may then be formed on the gate dielectric in order to control the performance and state of the transistor channels defined under the gate dielectric.

As will be appreciated by those skilled in the art, an embodiment of the basic structure according to the invention is illustrated in FIG. 4 may be configured in a manner wherein the NMOS devices are formed in the first transistor area A and the PMOS devices are formed in the second transistor area B. In such an instance, the orientation of the first and second conductivity type wells, 1p, will be (110) with p- and n-doping levels. This configuration may be reversed whereby the PMOS devices are formed in the first transistor area A and the NMOS devices are formed in the second transistor area B. In such an instance, the orientation of the first and second conductivity type wells, 1p, will be (100) with n- and p-doping levels respectively.

The epitaxial pattern 20 includes at least two facets that exhibit a different surface crystal orientation than the substrate 1p and may be formed from a single epitaxial semiconductor pattern 17 or from a plurality of patterns 17, 19 that may, in turn, be formulated or selected to provide a desired heterogeneous epitaxial semiconductor pattern. As used herein, the term heterogeneous epitaxial semiconductor pattern corresponds to an epitaxial pattern 20 in which the upper or surface epitaxial pattern 19 has the same surface crystal orientation as the lower or core epitaxial pattern 17 but has a different lattice constant.

A semiconductor device fabricated according to an embodiment of the invention incorporating a heterogeneous epitaxial semiconductor pattern 20 will tend to reflect a strained semiconductor layer 19. For example, selecting materials whereby the lattice constant for the lower or core epitaxial pattern 17, $LC_{core}$, and the upper or surface epitaxial pattern 19, $LC_{surface}$, satisfy the expression (1):

$$LC_{core} > LC_{surface} \qquad (1)$$

thereby producing an upper epitaxial pattern 19 that is under tension, further increasing the electron mobility and improving NMOS performance. Such a result may be achieved with various pairings of materials including, for example, the core/surface configurations:

Si/SiC,
SiGe/Si,
SiGe/SiC,
Ge/Si,
Ge/SiC, and
Ge/SiGe.

Conversely, the materials may be selected whereby the lattice constant for the lower or core epitaxial pattern 17 and the upper or surface epitaxial pattern 19, satisfy the expression (2):

$$LC_{core} < LC_{surface} \qquad (2)$$

thereby producing an upper epitaxial pattern 19 that is under compression, further increasing the hole mobility and improving PMOS performance. Such a result may be achieved with various pairings of materials including, for example, the core/surface configurations:

SiC/Si,
Si/SiGe,
SiC/SiGe,

Si/Ge,
SiC/Ge, and
SiGe/Ge.

The facets produced on the epitaxial pattern 20 that incorporates a surface or upper layer 19, typically $19f^1$ and, optionally, $19f^2$, form an acute angle with the surface of the first active area 11a. As noted above, both the surface or upper epitaxial layer 19 the lower or core epitaxial layer 17 typically include a top surface 17t, 19t that exhibits the same surface crystal orientation as the corresponding substrate orientation 1p. The faceted epitaxial semiconductor structure also includes at least a first pair of facets $17f^1$, and possibly $19f^1$, that have a different surface crystal orientation that the corresponding substrate orientation 1p. The lower epitaxial layer 17 may also incorporate a faceted epitaxial semiconductor structure having a second pair of facets $17f^2$, and possible $19f^2$, having a surface crystal orientation that differs from both the substrate orientation and the first pair(s) of facets.

The sizing and configuration of one or more transistors will tend to determine the size of the top surface 17t, 19t, if any. Because improvements in the resulting transistors are function of the availability of channel regions having a crystal orientation that differs from that of the base substrate 1 a length ratio between the facet length and the top length included in the channel should be at least 1:1 and preferably 3:1,5:1 or greater. Indeed, in some instances, it may be possible to eliminate a top surface from the faceted epitaxial semiconductor structure, leaving only facet surfaces for channel formation. As will be appreciated, the device performance will typically continue to improve as the length ratio between the facet length and the top length increased, reflecting greater portions of the channel being formed on facet surfaces.

The surface orientation of the facets depends on the surface orientation of the substrate 1p, on which the faceted epitaxial semiconductor structure is grown. If the substrate 1 has a surface that exhibits a (100) crystal orientation, then it is preferable that one of $17f^1$ and $17f^2$ (and $19f^1$ and $19f^2$, if present) has a (110) surface crystal orientation. Conversely, if the substrate exhibits a (110) oriented surface, then it is preferable that one of $17f^1$ and $17f^2$ (and $19f^1$ and $19f^2$, if present) has an (100) surface crystal orientation.

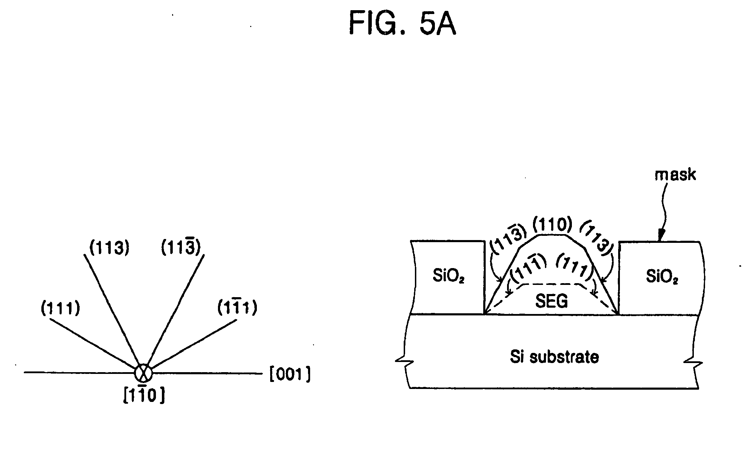

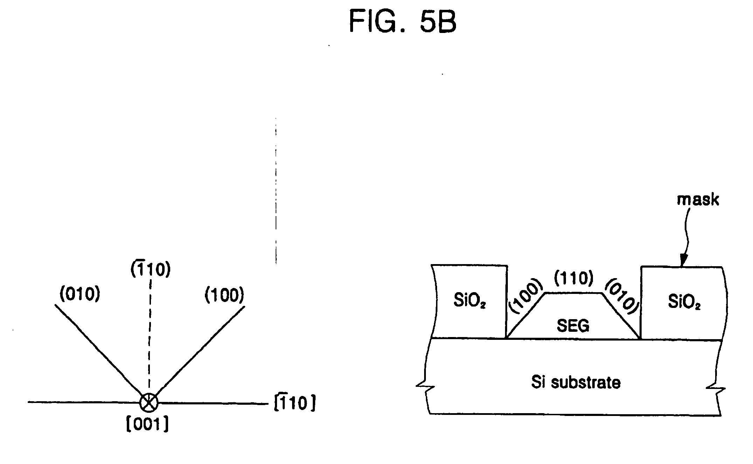

As will be appreciated by those skilled in the art, the facets produced may, as illustrated, be generally symmetrical about a central vertical longitudinal plane bisecting the gate structure(s). In such an instance, the surface crystal orientation of the opposing facets will be of similar size and extent and will have surface crystal orientations that differ only in the reversed sign of at least one intercept in the crystallographic expression, e.g., as illustrated in FIG. 5A, or in the reversed intercepts of two of the three axes, e.g., as illustrated in FIG. 5B. Conversely, the surrounding structures or configuration of the initial surface may be selected or prepared in a manner that produces an asymmetrical structure, e.g., one in which the "mirroring" facet is absent, of a different size and/or expresses a crystalline structure that does not "mirror", *i.e.,* is not in the same family of planes {h,l,k} as, the opposite facet surface.

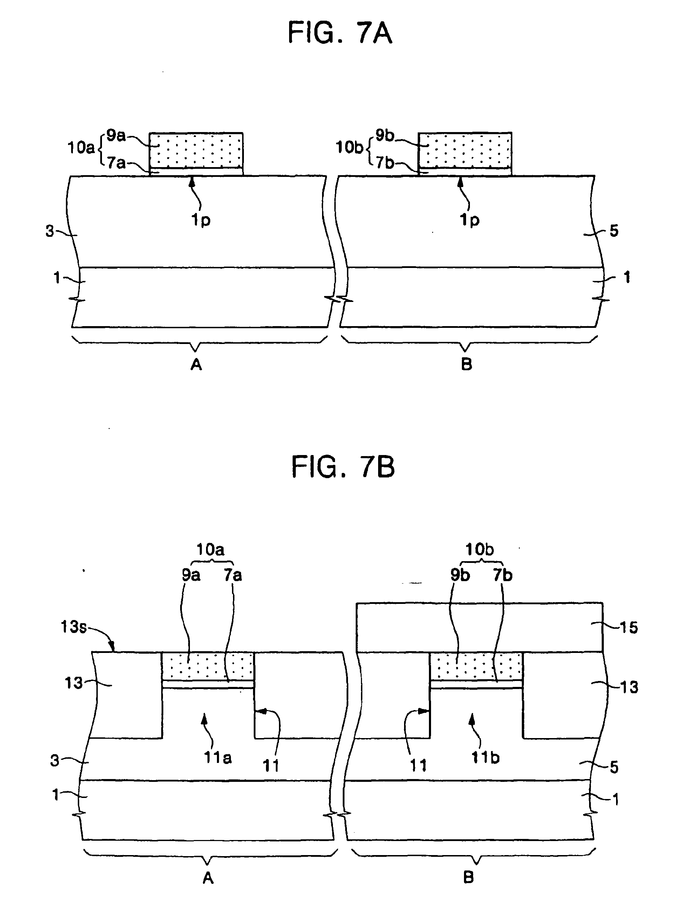

A fabrication process according to an embodiment of the invention is illustrated in FIGS. 7A-7E and is described in more detail below. As illustrated in FIG. 7A, a first well 3 is formed in first transistor area A and a second well 5 is formed in second transistor area B in the base substrate 1 that exhibits a first surface crystal orientation 1p. As noted above, the substrate 1 may be selected from a number of materials including, for example, Si, SiGe and SiC, suitable for forming single crystal semiconductor substrates. A first isolation pattern 10a and a second isolation pattern 10b are then formed on the first and second wells 3, 5 respectively. The isolation patterns may be formed from a stack of pad silicon oxide 7a, 7b and a pad silicon nitride 9a, 9b that were patterned and etched using a suitable photolithographic process.

The substrate 1 is then etched using the isolation patterns 10a, 10b to form trenches that separate and define a first active area 11a and a second active area 11b. The trenches are then filled with an insulating material, for example silicon oxide, and the upper portion of the insulating material is removed by, for example, a chemical mechanical polishing (CMP) process to expose the upper surface of the isolation patterns and thereby form the shallow trench isolation layers 13 to obtain the structure suggested in FIG. 7B. As illustrated in FIG. 7B, a photoresist pattern 15 is then formed to shield the second transistor area B and the isolation pattern in the first transistor area A is removed to expose a portion of the surface of the substrate 1.

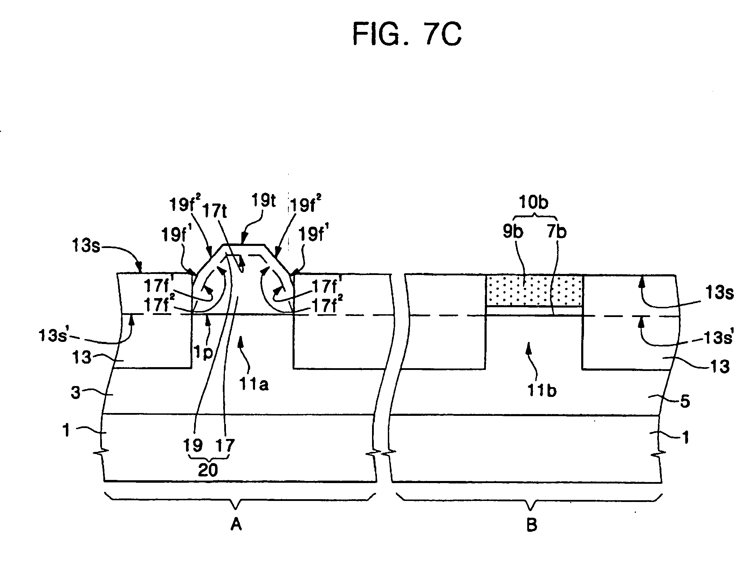

As illustrated in FIG. 7C, the first isolation pattern 10a is removed from the first transistor area A and the photoresist pattern 15 is removed from the second transistor area B. During the formation of the faceted epitaxial semiconductor structure, it is generally preferable to inhibit or suppress lateral growth of the epitaxial pattern from the exposed semiconductor surface. The epitaxial pattern that grows on the surface of the shallow trench isolation layer 13 will typically have either a polycrystalline structure or an amorphous structure.

The choice of processing conditions and the duration of any etch processes will determine the extent to which the surface of the shallow trench isolation layer 13 could be recessed (for example from 13s to the 13s[1]). Once the surface is substantially free of organic matter, the epitaxial pattern 20 may be grown on the exposed semiconductor surface in the first transistor area A. The epitaxial pattern 20 will include facets having a different surface crystal orientation than that of the substrate surface 1p from which it extends.

As discussed in some detail above, the epitaxial pattern 20 may constitute only a single epitaxial semiconductor pattern 17 or, in the alternative, may constitute a heterogeneous epitaxial semiconductor pattern that includes both a core pattern 17 and a surface pattern 19. As also discussed above, depending on the selection of the materials used to form the core and surface patterns 17, 19 the upper or surface epitaxial layer 19 can be configured as a strained semiconductor layer under either tension or compression for further altering the mobility of carriers within the channel region.

Each of the facets formed on the epitaxial pattern 20 are arranged at an acute angle relative to the surfaces of the first and second active areas 11a, 11b. Further, as discussed above, in light of the performance advantages provided by the facet surfaces, it is generally preferable to increase the relative length of the facets over the length of the top surface (if any) that will simply reflect the crystal orientation of the substrate 1p. The range of surface orientations that may be reflected in or exhibited by the facets depends on the surface orientation 1p of the original or base substrate 1 and the crystalline structure of the semiconductor material, but will generally be limited to a fairly small group of crystal orientations including, for example, the (111), (113), (110), (100) and (010) crystal orientations as well as the corresponding "mirror" orientations that will be expressed in the exposed surface of corresponding facet surfaces in more symmetrical structures, for example, ($\overline{1}$11), ($\overline{1}$13), (11$\overline{3}$), (1$\overline{1}$0) and (010).

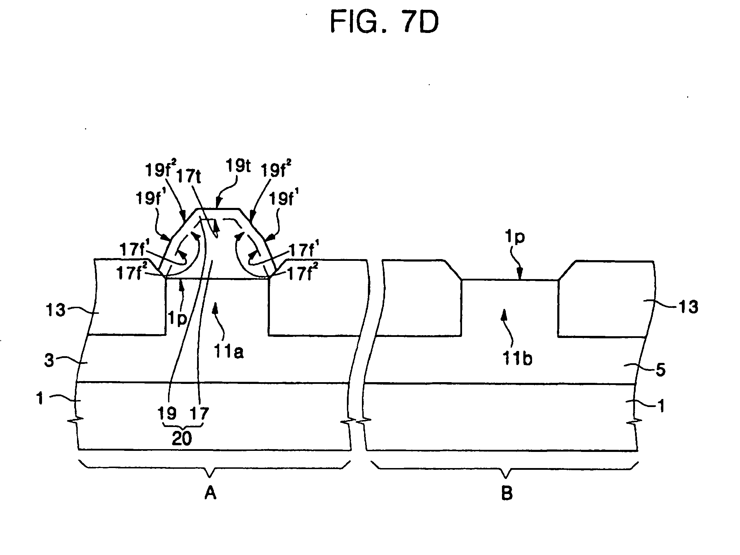

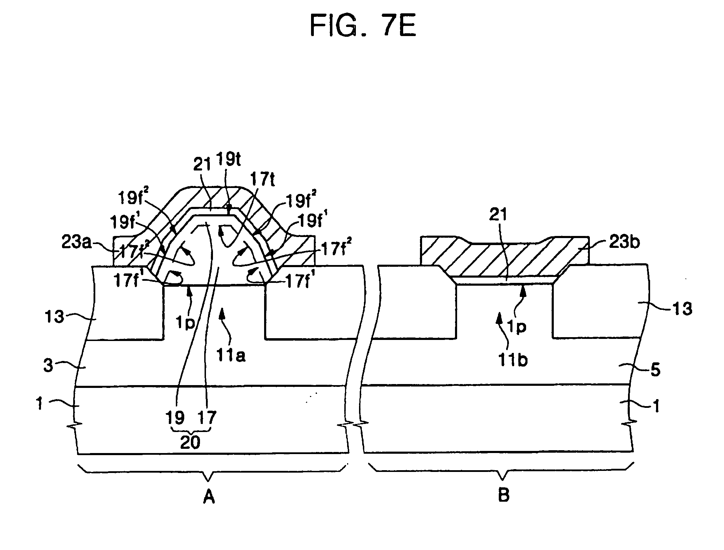

As illustrated in FIG. 7D, the second isolation pattern 10b is then removed to expose the surface of the active area in the second transistor area B. As illustrated in FIG. 7E, a gate dielectric 21 is then formed on the exposed semiconductor surfaces of the second active area as well as the exposed surfaces of the faceted epitaxial semiconductor structure. A gate electrode stack layer 23 is then formed over the gate dielectric 21 in the first and second active areas 11a, 11b, patterned and etched to form a first gate pattern 23a and a second gate pattern 23b respectively. Additional processing including, for example, source/drain regions ion implantation, metallization, testing and packaging, will typically be performed to complete the semiconductor fabrication process and produce a useful semiconductor device.

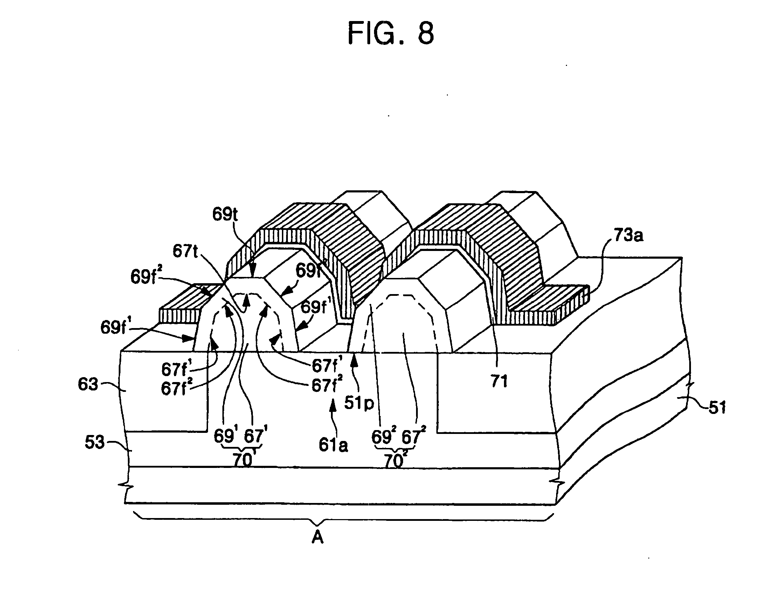

An active area of a semiconductor device according to another example embodiment of the invention is illustrated in FIG. 8 in which a plurality of epitaxial patterns 70[1], 70[2] are formed in a single active area 61a. As illustrated in FIG. 8, the epitaxial patterns may generally be arranged in a parallel configuration, but the patterns may also be arranged in other configurations, e.g., perpendicular or at some other angular offset (not shown) in some instances. The multiple epitaxial patterns will serve to increase the effective surface area of the active area 61a in which the patterns are formed and thereby improve current drivability.

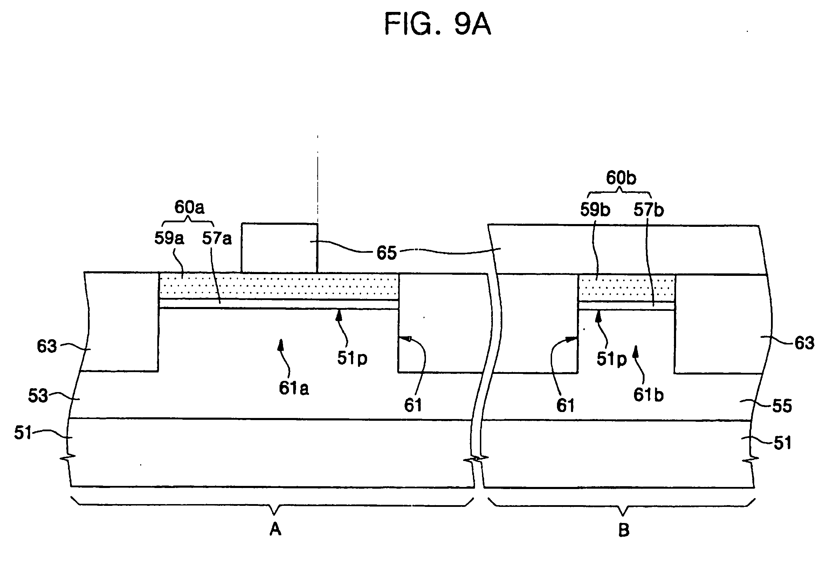

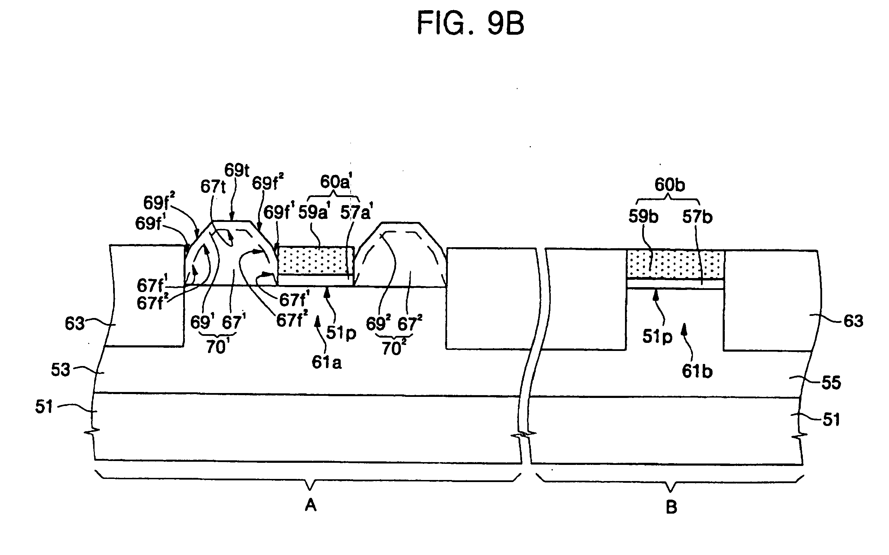

As illustrated in FIGS. 9A-9C, the second example embodiment may be manufactured using a process similar to that utilized for fabricating the first example embodiment. As illustrated in FIG. 9A, a first well 53 is formed in the first transistor area A and a second well 55 is formed in the second transistor area B in a base substrate 51. A first isolation pattern 60a, a second isolation pattern 60b and shallow trench isolation layers 63 are then formed on the first and second wells 53, 55. Portions of the first isolation pattern 60a are then removed to expose a plurality of semiconductor surface regions within the first well 53 while the remainder of the photoresist pattern 65 protects the second well 55 structures. The photoresist pattern 65 is then removed and the faceted epitaxial semiconductor structures are grown on the exposed semiconductor surfaces within the first well 53.

As discussed in some detail above, the epitaxial pattern $70^1$, $70^2$ may constitute only a single epitaxial semiconductor layer 67 or, in the alternative, may constitute a heterogeneous epitaxial semiconductor pattern that includes both a core layer 67 and a surface layer 69. Both the core layer and surface layer (if present) will tend to have a series of facets (67t, $67f^1$ and $67f^2$ on the core layer and 69t, $69f^1$ and $69f^2$ on the surface layer) As also discussed above, depending on the selection of the materials used to form the core and surface layers 67, 69 the upper or surface epitaxial layer 69 can be configured as a strained semiconductor layer under either tension or compression for further altering the mobility of carriers within the channel region.

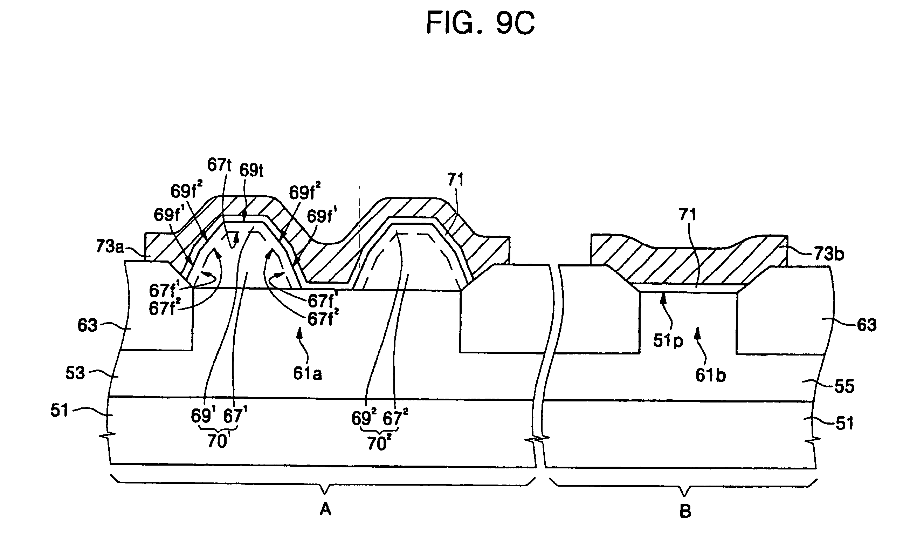

As illustrated in FIG. 9C, the second isolation pattern 60b is then removed to expose the surface of the active area in the second transistor area B. As illustrated in FIG. 9C, a gate dielectric 71 is then formed on the exposed semiconductor surfaces of the second active area as well as the exposed surfaces of the faceted epitaxial semiconductor structure. A gate electrode stack layer 73 is then formed over the gate dielectric 71 in the first and second active areas 61 a, 61 b, patterned and etched to form a first gate pattern 73a and a second gate pattern 73b respectively. Additional processing including, for example, source/drain regions ion implantation, metallization, testing and packaging, will typically be performed to complete the semiconductor fabrication process and produce a useful semiconductor device.

Although the invention has been described in connection with certain exemplary embodiments, it will be evident to those of ordinary skill in the art that many alternatives, modifications, and variations may be made to the disclosed methods in a manner consistent with the detailed description provided above. Also, it will be apparent to those of ordinary skill in the art that certain aspects of the various disclosed exemplary embodiments could be used in combination with aspects of any of the other disclosed embodiments or their alternatives to produce additional, but not herein illustrated, embodiments incorporating the claimed invention but more closely adapted for an intended use or performance requirements. Accordingly, it is intended that all such alternatives, modifications and variations that fall within the scope of the appended claims.

**Claims**

1.  A semiconductor device comprising:

    a semiconductor substrate (1) having a PMOS active area (11b) and an NMOS active area (11a), wherein
    the PMOS active area includes
    a first primary semiconductor surface (1p) having a (110)-crystal orientation,
    a first gate dielectric layer (21) formed on the first primary surface, and a first gate electrode (23b) formed on the first gate dielectric layer; and the NMOS active area includes
    a second gate dielectric layer (21) and
    a second gate electrode (23a) formed on the second gate dielectric layer;
    **characterized in that**
    the NMOS active area further includes a faceted, epitaxially grown semiconductor structure (20) formed on a virtual second primary semiconductor surface 1p) having the (110)-crystal orientation and being at the same level as the first primary semiconductor surface, the faceted semiconductor surface comprising a facet surface ($17f^1$) that has a (100)-crystal orientation and extends from the virtual second primary semiconductor surface, with the second gate dielectric layer (21) being formed on said facet surface.

2.  The semiconductor device according to claim 1, wherein the faceted epitaxial semiconductor structure has a first pair of facet surfaces ($17f^1$) having a second crystal orientation different from the (110)-crystal orientation and a corresponding second mirrored crystal orientation and a second pair of facet surfaces ($17f^2$) having a third crystal orientation different from the (110)- and (100)-crystal orientations and a corresponding third mirrored crystal orientation.

3.  The semiconductor device according to claim 2, wherein the first pair of facet surfaces has (113)- and ($11\bar{3}$)-crystal orientations or has different crystal orientations selected from a family of equivalent {113} planes and the second pair of facet surfaces has (111)-and ($11\bar{1}$)-crystal orientations or has different crystal orientations selected from a family of equivalent {111} planes.

4.  The semiconductor device according to any of claims 1 to 3, wherein the faceted epitaxial semiconductor structure has a top surface (17t) having the (110)-crystal orientation arranged between a pair of facet surfaces that form obtuse angles with the top surface.

**5.** The semiconductor device according to any of claims 1 to 4, wherein the faceted epitaxial semiconductor structure includes a core material and a surface layer.

**6.** The semiconductor device according to claim 5, wherein the core material has a first lattice constant $L_C$ and a surface layer has a second lattice constant $L_S$, preferably the first and second lattice constants satisfying the expression $L_C>L_S$ or $L_c<L_s$.

**7.** The semiconductor device according to claim 5 or 6, wherein the core material and surface layer are selected from a group consisting of Si, SiC, SiGe, Ge and combinations thereof.

**8.** The semiconductor device according to any of claims 1 to 7, further comprising:

two faceted epitaxial semiconductor structures formed on the virtual second primary semiconductor surface with lateral distance from one another, each including at least one facet surface that has the (100)-crystal orientation, gate dielectric layers formed on the facet surfaces of the first and second faceted epitaxial semiconductor structures, and a gate electrode formed on the gate dielectric layers.

**9.** A method of forming a semiconductor device, comprising the following steps:

forming a PMOS active area (11b) having a first primary semiconductor surface and an NMOS active area (11a) having a second primary semiconductor surface, both the first and second primary semiconductor surfaces having a (110)-crystal orientation and being on a same level; forming a faceted epitaxial semiconductor structure (20) having at least one facet surface that has a (100)-crystal orientation by epitaxial growth on and from the second primary semiconductor surface, forming gate dielectric layers (21) on the first primary semiconductor surface and the facet surfaces, and forming gate electrodes (23a, 23b) on the gate dielectric layers.

**10.** The method according to claim 9, wherein forming the faceted epitaxial semiconductor structure includes forming a first pair of facet surfaces, one facet surface having a second crystal orientation different from the (110)-crystal orientation and the other having a corresponding second mirrored crystal orientation, and forming a second pair of facet surfaces, one facet surface having a third crystal orientation different from the (110)-and (100)-orientations and the other having a corresponding third mirrored crystal orientation.

**11.** The method according to claim 9, wherein forming the faceted epitaxial semiconductor structure includes forming a first pair of facet surfaces that have the a crystal orientation different from the (110)-crystal orientation, and forming a top surface having the (110)-crystal orientation arranged between a pair of facet surfaces that form obtuse angles with the top surface.

**12.** The method according to any of claims 9 to 11, wherein forming the faceted epitaxial semiconductor structure includes forming a core material; and forming a surface layer on the core material.

**13.** The method according to claim 12, wherein:

forming the core material includes forming a material having a first lattice constant $L_C$, and forming the surface layer includes forming a material having a second lattice constant $L_S$, wherein the first and second lattice constants satisfy the expression $L_C>L_S$ or $L_c<L_s$.

**14.** The method according to claim 12 or 13, wherein the core material and surface layer are selected from a group consisting of Si, SiC, SiGe, Ge and combinations thereof.

**15.** The method according to any of claims 9 to 14, further comprising:

forming first and second faceted epitaxial semiconductor structures laterally spaced from one another on the second primary semiconductor surface, each of the first and second faceted epitaxial semiconductor structures including at least one facet surface; forming gate dielectric layers on the facet surfaces of the first and second faceted epitaxial semiconductor structures, and forming a gate electrode on the gate dielectric layers.

**16.** The method according to any of claims 9 to 15, wherein a semiconductor device having the features of any of claims 1 to 8 is manufactured.

**Patentansprüche**

1. Halbleiterbauelement mit einem Halbleitersubstrat (1), das einen aktiven PMOS-Bereich (11b) und einen aktiven NMOS-Bereich (11a) aufweist, wobei der aktive PMOS-Bereich umfasst:

   - eine erste Halbleiter-Hauptfläche (1 p) mit einer (110)-Kristallorientierung,
   - eine erste Gatedielektrikumschicht (21), die auf der ersten Hauptfläche gebildet ist, und
   - eine erste Gateelektrode (23b), die auf der ersten Gatedielektrikumschicht gebildet ist, und

   der aktive NMOS-Bereich umfasst:

   - eine zweite Gatedielektrikumschicht (21) und
   - eine zweite Gateelektrode (23a), die auf der zweiten Gatedielektrikumschicht gebildet ist,

   **dadurch gekennzeichnet, dass**
   der aktive NMOS-Bereich des Weiteren eine facettierte, epitaktisch gewachsene Halbleiterstruktur (20) aufweist, die auf einer virtuellen zweiten Halbleiter-Hauptfläche (1 p) mit der (110)-Kristallorientierung gebildet ist und sich auf gleicher Höhe wie die erste Halbleiter-Hauptfläche befindet, wobei die facettierte Halbleiterstruktur eine Facettenfläche (17f$^1$) aufweist, die eine (100)-Kristallorientierung besitzt und sich von der virtuellen zweiten Halbleiter-Hauptfläche erstreckt, wobei die zweite Gatedielektrikumschicht (21) auf der Facettenfläche gebildet ist.

2. Halbleiterbauelement nach Anspruch 1, wobei die facettierte epitaktische Halbleiterstruktur ein erstes Paar von Facettenflächen (17f$^1$) mit einer zweiten Kristallorientierung verschieden von der (110)-Kristallorientierung und mit einer korrespondierenden zweiten gespiegelten Kristallorientierung sowie ein zweites Paar von Facettenflächen (17f$^2$) mit einer dritten Kristallorientierung verschieden von den (110)- und (100)-mit einer korrespondierenden dritten gespiegelten Kristallorientierung aufweist.

3. Halbleiterbauelement nach Anspruch 2, wobei das erste Paar von Facettenflächen (113)- und (11$\bar{3}$)-Kristallorientierungen oder unterschiedliche Kristallorientierungen aufweist, die aus einer Familie von äquivalenten {113}-Ebenen ausgewählt sind, und das zweite Paar von Facettenflächen (111)- und (11$\bar{1}$)-Kristallorientierungen oder unterschiedliche Kristallorientierungen aufweist, die aus einer Familie äquivalenter {111}-Ebenen ausgewählt sind.

4. Halbleiterbauelement nach einem der Ansprüche 1 bis 3, wobei die facettierte epitaxiale Halbleiterstruktur eine Oberseite (17t) mit der (110)-Kristallorientierung angeordnet zwischen einem Paar von Facettenflächen aufweist, die stumpfe Winkel mit der Oberseite bilden.

5. Halbleiterbauelement nach einem der Ansprüche 1 bis 4, wobei die facettierte epitaxiale Halbleiterstruktur ein Kernmaterial und eine Oberflächenschicht umfasst.

6. Halbleiterbauelement nach Anspruch 5, wobei das Kernmaterial eine erste Gitterkonstante L$_C$ und eine Oberflächenschicht mit einer zweiten Gitterkonstante L$_S$ aufweist, wobei vorzugsweise die erste und zweite Gitterkonstante die Beziehung L$_C$>L$_S$ oder L$_C$<L$_S$ erfüllen.

7. Halbleiterbauelement nach Anspruch 5 oder 6, wobei das Kernmaterial und die Oberflächenschicht aus einer Gruppe ausgewählt sind, die aus Si, SiC, SiGe, Ge und Kombinationen hiervon besteht.

8. Halbleiterbauelement nach einem der Ansprüche 1 bis 7, weiter umfassend:

   zwei facettierte epitaxiale Halbleiterstrukturen, die auf der virtuellen zweiten Halbleiter-Hauptfläche mit lateralem Abstand voneinander gebildet sind, wobei jede wenigstens eine Facettenfläche mit der (100)-Kristallorientierung beinhaltet,
   Gatedielektrikumschichten, die auf den Facettenflächen der ersten und der zweiten facettierten epitaxialen Halbleiterstruktur gebildet sind, und
   eine Gateelektrode, die auf den Gatedielektrikumschichten gebildet ist.

9. Verfahren zur Herstellung eines Halbleiterbauelements, mit folgenden Schritten:

   - Bilden eines aktiven PMOS-Bereichs (11b) mit einer ersten Halbleiter-Hauptfläche und eines aktiven NMOS-Bereichs (11a) mit einer zweiten Halbleiter-Hauptfläche, wobei die erste und die zweite Halbleiter-Hauptfläche beide eine (110)-Kristallorientierung aufweisen und sich auf gleicher Höhe befinden,
   - Bilden einer facettierten epitaxialen Halbleiterstruktur (20) mit wenigstens einer Facettenfläche, die eine (110)-Kristallorientierung aufweist, durch epitaktisches Wachstum auf und von der zweiten Halbleiter-Hauptfläche,
   - Bilden von Gatedielektrikumschichten (21) auf der ersten Halbleiter-Hauptfläche und den Facettenflächen und
   - Bilden von Gateelektroden (23a, 23 b) auf den Gatedielektrikumschichten.

**10.** Verfahren nach Anspruch 9, wobei das Bilden der facettierten epitaxialen Halbleiterstruktur umfasst:

- Bilden eines ersten Paares von Facettenflächen, von denen eine Facettenfläche eine zweite Kristallorientierung verschieden von der (110)-Kristallorientierung aufweist und die andere eine entsprechende zweite gespiegelte Kristallorientierung aufweist und

- Bilden eines zweiten Paares von Facettenflächen, von denen eine Facettenfläche eine dritte Kristallorientierung verschieden von den (110)- und (100)-Kristallorientierungen aufweist und die andere eine entsprechende dritte gespiegelte Kristallorientierung aufweist.

**11.** Verfahren nach Anspruch 9, wobei das Bilden der facettierten epitaxialen Halbleiterstruktur umfasst:

- Bilden eines ersten Paares von Facettenflächen, die eine von der (110)-Kristallorientierung verschiedene Kristallorientierung aufweisen, und

- Bilden einer Oberseite mit der (110)-Kristallorientierung zwischen einem Paar von Facettenflächen, die stumpfe Winkel mit der Oberseite bilden.

**12.** Verfahren nach einem der Ansprüche 9 bis 11, wobei das Bilden der facettierten epitaxialen Halbleiterstruktur umfasst:

- Bilden eines Kernmaterials und
- Bilden einer Oberflächenschicht auf dem Kernmaterial.

**13.** Verfahren nach Anspruch 12, wobei

- das Bilden des Kernmaterials die Bildung eines Materials mit einer ersten Gitterkonstanten $L_C$ beinhaltet und

- das Bilden der Oberflächenschicht die Bildung eines Materials mit einer zweiter Gitterkonstanten $L_S$ beinhaltet, wobei die erste und die zweite Gitterkonstante die Beziehung $L_C > L_S$ oder $L_C < L_S$ erfüllen.

**14.** Verfahren nach Anspruch 12 oder 13, wobei das Kernmaterial und die Oberflächenschicht aus einer Gruppe ausgewählt werden, die aus Si, SiC, SiGe, Ge und Kombinationen hiervon besteht.

**15.** Verfahren nach einem der Ansprüche 9 bis 14, weiter umfassend:

- Bilden einer ersten und einer zweiten facettierten epitaxialen Halbleiterstruktur auf der zweiten Halbleiter-Hauptfläche, die voneinander lateral beabstandet sind, wobei die erste und die zweite facettierte epitaxiale Halbleiterstruktur jeweils wenigstens eine Facettenfläche aufweisen,

- Bilden von Gatedielektrikumschichten auf den Facettenflächen der ersten und der zweiten facettierten epitaxialen Halbleiterstruktur und

- Bilden einer Gateelektrode auf den Gatedielektrikumschichten.

**16.** Verfahren nach einem der Ansprüche 9 bis 15, wobei ein Halbleiterbauelement mit den Merkmalen nach einem der Ansprüche 1 bis 8 hergestellt wird.

**Revendications**

**1.** Dispositif à semi-conducteur comprenant :

un substrat semi-conducteur (1) comportant une zone active PMOS (11b) et une zone active NMOS (11a), dans lequel

la zone active PMOS inclut

une première surface de semi-conducteur primaire (1p) présentant une orientation cristalline (110),

une première couche de diélectrique de grille (21) formée sur la première surface primaire, et une première électrode de grille (23b) formée sur la première couche de diélectrique de grille, et

la zone active NMOS inclut

une deuxième couche de diélectrique de grille (21) et

une deuxième électrode de grille (23a) formée sur la deuxième couche de diélectrique de grille ;

**caractérisé en ce que**

la zone active NMOS inclut en outre une structure de semi-conducteur à croissance épitaxiale à facettes (20) formée sur une deuxième surface de semi-conducteur primaire virtuelle (1 p) présentant l'orientation cristalline (110) et étant au même niveau que la première surface de semi-conducteur primaire, la surface de semi-conducteur à facettes comprenant une surface de facette (17f[1]) qui présente une orientation cristalline (100) et s'étend à partir de la deuxième surface de semi-conducteur primaire virtuelle, la deuxième couche de diélectrique de grille (21) étant formée sur ladite surface de facette.

**2.** Dispositif à semi-conducteur suivant la revendication 1, dans lequel la structure de semi-conducteur épitaxiale à facettes comporte une première paire de surfaces de facette (17f[1]) présentant une deuxième orientation cristalline différente de l'orientation cristalline (110) et une deuxième orientation cristalline inverse correspondante et une deuxième paire de surfaces de facette (17f$^2$) présentant une troisième orientation cristalline différente des orientations cristallines (110) et (100) et une troisième orientation cristalline inverse correspondante.

3. Dispositif à semi-conducteur suivant la revendication 2, dans lequel la première paire de surfaces de facette présente des orientations cristallines (113) et (11$\overline{3}$) ou présente des orientations cristallines différentes choisies parmi une famille de plans {113} équivalents et la deuxième paire de surfaces de facette présente des orientations cristallines (111) et (11$\overline{1}$) ou présente des orientations cristallines différentes choisies parmi une famille de plans {111} équivalents.

4. Dispositif à semi-conducteur suivant l'une quelconque des revendications 1 à 3, dans lequel la structure de semi-conducteur épitaxiale à facettes comporte une surface supérieure (17t) présentant l'orientation cristalline (110) disposée entre une paire de surfaces de facette qui forment des angles obtus avec la surface supérieure.

5. Dispositif à semi-conducteur suivant l'une quelconque des revendications 1 à 4, dans lequel la structure de semi-conducteur épitaxiale à facettes inclut un matériau du noyau et une couche de surface.

6. Dispositif à semi-conducteur suivant la revendication 5, dans lequel le matériau du noyau présente une première constante de réseau cristallin $L_C$ et une couche de surface présente une deuxième constante de réseau cristallin $L_S$, la première et la deuxième constantes de réseau cristallin satisfaisant de préférence l'expression $L_C > L_S$ ou $L_C < L_S$.

7. Dispositif à semi-conducteur suivant la revendication 5 ou 6, dans lequel le matériau du noyau et la couche de surface sont choisis parmi un groupe composé du Si, du SiC, du SiGe, du Ge et des combinaisons de ceux-ci.

8. Dispositif à semi-conducteur suivant l'une quelconque des revendications 1 à 7, comprenant en outre :

   deux structures de semi-conducteur épitaxiales à facettes formées sur la deuxième surface de semi-conducteur primaire virtuelle avec une distance latérale l'une par rapport à l'autre, chacune incluant au moins une surface de facette qui présente l'orientation cristalline (100),
   des couches de diélectrique de grille formées sur les surfaces de facette de la première et de la deuxième structures de semi-conducteur épitaxiales à facettes, et
   une électrode de grille formée sur les couches de diélectriques de grille.

9. Procédé de formation d'un dispositif à semi-conducteur, comprenant les étapes suivantes :

   la formation d'une zone active PMOS (11 b) comportant une première surface de semi-conducteur primaire et une zone active NMOS (11a) comportant une deuxième surface de semi-conducteur primaire, la première et la deuxième surfaces de semi-conducteur primaires présentant toutes deux une orientation cristalline (110) et étant au même niveau,
   la formation d'une structure de semi-conducteur épitaxiale à facettes (20) comportant au moins une surface de facette qui présente une orientation cristalline (100) par croissance épitaxiale sur et à partir de la deuxième surface de semi-conducteur primaire,
   la formation de couches de diélectrique de grille (21) sur la première surface de semi-conducteur primaire et les surfaces de facette, et
   la formation d'électrodes de grille (23a, 23b) sur les couches de diélectriques de grille.

10. Procédé suivant la revendication 9, dans lequel la formation de la structure de semi-conducteur épitaxiale à facettes inclut
   la formation d'une première paire de surfaces de facette, une surface de facette présentant une deuxième orientation cristalline différente de l'orientation cristalline (110) et l'autre présentant une deuxième orientation cristalline inverse correspondante, et
   la formation d'une deuxième paire de surfaces de facette, une surface de facette présentant une troisième orientation cristalline différente des orientations cristallines (110) et (100) et l'autre présentant une troisième orientation cristalline inverse correspondante.

11. Procédé suivant la revendication 9, dans lequel la formation de la structure de semi-conducteur épitaxiale à facettes inclut
   la formation d'une première paire de surfaces de facette qui présentent une orientation cristalline différente de l'orientation cristalline (110), et
   la formation d'une surface supérieure présentant l'orientation cristalline (110) disposée entre une paire de surfaces de facette qui forment des angles obtus avec la surface supérieure.

12. Procédé suivant l'une quelconque des revendications 9 à 11, dans lequel la formation de la structure de semi-conducteur épitaxiale à facettes inclut
   la formation d'un matériau du noyau, et
   la formation d'une couche de surface sur le matériau du noyau.

**13.** Procédé suivant la revendication 12, dans lequel :

la formation du matériau du noyau inclut la formation d'un matériau présentant une première constante de réseau cristallin $L_C$, et la formation de la couche de surface inclut la formation d'un matériau présentant une deuxième constante de réseau cristallin $L_S$, dans lequel la première et la deuxième constantes de réseau cristallin satisfont l'expression $L_C > L_S$ ou $L_C < L_S$.

**14.** Procédé suivant la revendication 12 ou 13, dans lequel le matériau du noyau et la couche de surface sont choisis parmi un groupe composé du Si, du SiC, du SiGe, du Ge et des combinaisons de ceux-ci.

**15.** Procédé suivant l'une quelconque des revendications 9 à 14, comprenant en outre :

la formation de la première et de la deuxième structures de semi-conducteur épitaxiales à facettes espacées l'une de l'autre dans le sens latéral sur la deuxième surface de semi-conducteur primaire, chacune des première et deuxième structures de semi-conducteur épitaxiales à facettes incluant au moins une surface de facette ; la formation de couches de diélectrique de grille sur les surfaces de facette de la première et de la deuxième structures de semi-conducteur épitaxiales à facettes, et la formation d'une électrode de grille sur les couches de diélectriques de grille.

**16.** Procédé suivant l'une quelconque des revendications 9 à 15, dans lequel est fabriqué un dispositif à semi-conducteur présentant les particularités de l'une des revendications 1 à 8.

# FIG. 1A

ELECTRON MOBILITY

# FIG. 1B

HOLE MOBILITY

# FIG. 2A

Step 1 Thin oxide/nitride deposition.

Step 2 SOI/BOX stack etching and spacer formation.

Step 3 Si epitaxy and CMP

Step 4 Si etch back and thin nitride/oxide strip.

Step 5 Shallow trench isolation.

Step 6 Continuing CMOS fabrication.

EP 1 677 350 B1

# FIG. 2B

Type A HOT CMOS

Type B HOT CMOS

# FIG. 3A

NMOS

# FIG. 3B

PMOS

FIG. 4

13
5
1

23b

21

1p 11b

B

19f²
19f¹
17f¹
17f²
11a

19 17
20

A

21

19t
17t
19f²
23a
19f¹

17f¹
17f²

13
3
1

# FIG. 5A

EP 1 677 350 B1

(113)   (11$\bar{3}$)

(111)                    (1$\bar{1}$1)

[001]

[1$\bar{1}$0]

mask

(11$\bar{3}$) (110) (113)

(11$\bar{1}$) (111)

SiO₂                    SiO₂

SEG

Si substrate

# FIG. 5B

$(\bar{1}10)$

(010)          (100)

⊗ —— [$\bar{1}$10]

[001]

mask

SiO₂   (100)   (110)   (010)   SiO₂

SEG

Si substrate

## FIG. 6A

## FIG. 6B

# FIG. 7A

# FIG. 7B

# FIG. 7C

EP 1 677 350 B1

# FIG. 7D

EP 1 677 350 B1

A

B

# FIG. 7E

EP 1 677 350 B1

# FIG. 8

EP 1 677 350 B1

# FIG. 9A

EP 1 677 350 B1

FIG. 9B

# FIG. 9C

EP 1 677 350 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030190791 A1
- WO 9716854 A1
- US 20030227036 A1
- WO 03003470 A2
- KR 20050000584

**Non-patent literature cited in the description**

- **Q. Xiang et al.** Sidewall faceting and inter-facet mass transport in selectively grown epitaxial layers on SiO2-masked Si (110) substrates. *Journal of Crystal Growth,* 1997, vol. 175/176, 469